# EUROPÄISCHE PATENTSCHRIFT

(11) **EP 1 261 501 B1**
(45) Veröffentlichungstag und Bekanntmachung des Hinweises auf die Patenterteilung: **14.10.2009**
(21) Anmeldenummer: 01915084.6
(22) Anmeldetag: 06.03.2001
(51) Int. Cl.: B60C 23/04, G01K 7/34

(54) **ERZEUGNIS MIT EINEM SENSOR UND EINEM OBERFLÄCHENWELLENELEMENT SOWIE VERFAHREN UND ANORDNUNG ZUR BESTIMMUNG EINER EINEM REAKTIVEN WIDERSTAND ENTSPRECHENDEN MESSGRÖSSE EINES SENSORS**
PRODUCT COMPRISING A SENSOR AND A SURFACE WAVE ELEMENT, AND METHOD AND SYSTEM FOR DETERMINING, FROM THE SENSOR, A MEASURED QUANTITY THAT CORRESPONDS TO A REACTIVE RESISTANCE
PRODUIT COMPRENANT UN CAPTEUR ET UN ELEMENT A ONDES DE SURFACE, AINSI QUE PROCEDE ET SYSTEME POUR DETERMINER UNE GRANDEUR DE MESURE D'UN CAPTEUR CORRESPONDANT A UNE RESISTANCE REACTIVE

(30) Priorität: 06.03.2000 DE 10010846
(43) Veröffentlichungstag der Anmeldung: 04.12.2002
(73) Patentinhaber: Continental Automotive GmbH, 30165 Hannover (DE)
(72) Erfinder: DOLLINGER, Franz, 82008 Unterhaching (DE); SCHIMETTA, Gernot, 80809 München (DE)
(86) Internationale Anmeldenummer: PCT/DE2001/000846
(87) Internationale Veröffentlichungsnummer: WO 2001/066367

(56) Entgegenhaltungen:
- EP-A- 0 450 653
- EP-A- 0 883 327
- WO-A-97/45277
- PATENT ABSTRACTS OF JAPAN vol. 008, no. 109 (P-275), 22. Mai 1984 (1984-05-22) & JP 59 017127 A (NISSAN JIDOSHA KK), 28. Januar 1984 (1984-01-28)

## Beschreibung

Erzeugnis mit einem Sensor und einem Oberflächenwellenelement sowie Verfahren und Anordnung zum Bestimmen einer einem reaktiven Widerstand entsprechenden Meßgröße von einem Sensor

Die Erfindung betrifft ein Erzeugnis mit einem Sensor, durch welchen eine einem reaktiven Widerstand entsprechende Meßgröße innerhalb eines Meßbereichs lieferbar ist, einem Anpassnetzwerk und einem Oberflächenwellenelement, wobei der Sensor über das Anpassnetzwerk an einen ersten Reflektor des Oberflächenwellenelements geschaltet ist und der erste Reflektor mit dem Anpassnetzwerk und dem Sensor einen Resonator bildet.

Außerdem betrifft die Erfindung ein Verfahren zum Bestimmen einer einem reaktiven Widerstand entsprechenden Meßgröße innerhalb eines Meßbereichs von einem Sensor, welcher über ein Anpassnetzwerk an einen ersten Reflektor eines Oberflächenwellenelements geschaltet ist und mit dem ersten Reflektor und dem Anpassnetzwerk einen Resonator bildet. Das Verfahren umfaßt folgende Schritte:
a) Erzeugen einer sich auf dem Oberflächenwellenelement ausbreitenden akustischen Oberflächenwelle;
b) Erzeugen einer ersten reflektierten Oberflächenwelle durch Reflektieren der Oberflächenwelle an dem ersten Reflektor;
c) Empfangen der ersten reflektierten Oberflächenwelle; und
d) Bestimmen der Meßgröße aus der reflektierten Oberflächenwelle.

Die Erfindung betrifft auch eine entsprechende Anordnung.

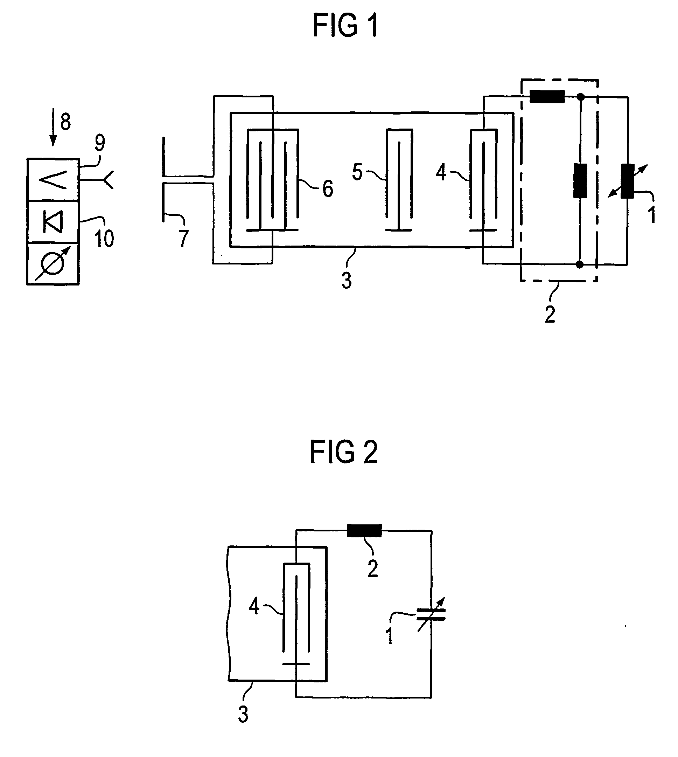

Ein solches Erzeugnis, ein solches Verfahren und eine solche Anordnung gehen hervor aus dem Aufsatz "SAW Delay Lines for Wirelessly Requestable Conventional Sensors" von R. Steindl, A. Pohl, L. Reindl und F. Seifert, 1998 IEEE Ultrasonics Symposium, Proceedings, Seiten 351 ff., siehe insbesondere Figuren 1, 4 und 5 nebst zugehöriger Beschreibung. Zusätzlich wird verwiesen auf den Aufsatz "Wirelessly Interrogable Sensors for Different Purposes in Industrial Radio Channels" derselben vier genannten Autoren, 1998 IEEE Ultrasonics Symposium, Proceedings, Seiten 347 ff., siehe insbesondere das Kapitel "Radio Request Methods", Seite 349 f. Schließlich wird verwiesen auf den Aufsatz "Funksensorik und Identifikation mit OFW-Sensoren" von L. Reindl, G. Scholl, T. Ostertag, F. Schmidt und A. Pohl, vorgetragen auf der ITG/GMA-Fachtagung "Sensoren und Meßsysteme" zwischen dem 09. und dem 11.03.1998 in Bad Nauheim, zu welchem Vortrag ein schriftliches Skript vorliegt. Von besonderem Interesse ist Bild 18 des Skriptes nebst zugehöriger Beschreibung.

Der vorliegend maßgebliche technologische Hintergrund erschließt sich aus den Aufsätzen "Surface Acoustic Wave Filters for Digital Radio Relay Systems" von G. Riha, H. Stocker und P. Zibis, Telcom Report 10 (1987) Special "Radio Communication" 241 und "Reproducible Fabrication of Surface Acoustic Wave Filters" von W. E. Bulst und E. Willibald-Riha, Telcom Report 10 (1987) Special "Radio Communication" 247. Von Bedeutung ist auch der Aufsatz "Programmable Reflectors for SAW-ID-Tags" von L. Reindl und W. Ruile, 1983 IEEE Ultrasonics Symposium, Proceedings, Seiten 125 ff.

In den letzten Jahren hat sich auf der Grundlage eines Bedürfnisses zur Überwachung von Meßgrößen wie Verschleiß, Druck und Temperatur in einem Reifen eines Personen- oder Lastkraftfahrzeuges die Technologie autonomer, drahtlos abfragbarer Sensormodule entfaltet. Besondere Vorteile verspricht dabei ein vollständig passives Sensormodul bestehend aus einem Oberflächenwellenelement, einer Antenne und einem Sensor nebst allfällig notwendigen Anpassnetzwerken. Ein solches Sensormodul erfordert keine eigenständige Stromversorgung, da zu jedem gewünschten Zeitpunkt die von dem Sensor bestimmte Meßgröße durch einen zu dem Modul gesandten hochfrequenten Impuls abgefragt wird. Dies ist in den eingangs genannten Aufsätzen detailliert erläutert. Ein solches Sensormodul kann unter Verwendung hochfrequenter Signale aus einem passenden Frequenzband (Frequenzbereich beispielsweise um 434 MHz) von einem mehrere Meter entfernten Auswertegerät abgefragt werden. Als Sensor kommen unter anderem ein Temperatursensor und ein Drucksensor in Frage, und das Sensormodul ist hinreichend klein und kompakt, um in einen herkömmlichen Automobilreifen eingebaut werden zu können.

Wie aus den drei eingangs zitierten Dokumenten hervorgeht, ist die Amplitude des an dem mit dem Sensor beschalteten Reflektor des Oberflächenwellenelements reflektierten Signals die für die Messung auszuwertende Größe und bestimmt somit die erreichbare Auflösung der Messung. Insbesondere ein Drucksensor hat als Meßgröße einen reaktiven Widerstand und ist mit dem Reflektor über ein Anpassnetzwerk derart verbindbar, daß er einen Resonator bildet, welcher eine der Variabilität der Meßgröße entsprechende Variabilität der Amplitude einer von dem Reflektor reflektierten akustischen Oberflächenwelle liefert. Die Auswertung der Amplitude der reflektierten Oberflächenwelle hat den Nachteil, daß ein Meßfehler betrachtet werden muß, der eine Funktion dieser Amplitude ist. Je niedriger die Amplitude, um so geringer ist der Abstand zwischen der Amplitude und dem stets vorhandenen Rauschen und desto geringer dementsprechend die erreichbare Auflösung. Da für eine sinnvolle Auswertung ein minimaler Abstand zwischen Signal und Rauschen (Rauschabstand) nicht unterschritten werden darf, wird somit der Dynamikbereich der Messung eingeschränkt. Auch ergibt sich eine Einschränkung hinsichtlich des Abstandes zwischen dem Auswertegerät und dem Sensormodul, da die vom Auswertegerät empfangbare Amplitude mit zunehmendem Abstand sinkt. Dementsprechend schließen sich hohe Reichweite und hohe Auflösung der Messung gemäß vorliegendem Stand der Technik aus.

Die WO 97/45277 offenbart eine Vorrichtung zur drahtlosen Übertragung aus bewegten Teilen. Die Vorrichtung betrifft die drahtlose Übertragung von mindestens einem Messwert aus bewegten Teilen, insbesondere zur Messung des Reifendrucks in Kraftfahrzeugen, bestehend aus einem Messwertgeber, insbesondere einem Druckmesser, im Reifen und einem Messsystem, welches seinerseits aus mindestens einer Antenne in der Nähe des Messwertgebers sowie mindestens einer Elektronik-Baugruppe besteht, wobei im Messsystem zumindest eine Speisefrequenz erzeugt und an den Messwertgeber abgestrahlt und von diesem empfangen wird. Es ist vorgesehen, dass der Messwertgeber aus mindestens einem Resonator gekoppelt mit mindestens einem nichtlinearen, elektronischen Bauteil besteht und der Resonator vom zu messenden Wert beeinflusst wird, dass durch Mischung oder Oberwellenbildung sich in dem nichtlinearen, elektronischen Bauteil Vielfache der Speisefrequenz oder Summen- oder Differenzfrequenzen mehrerer Speisefrequenzen bilden, und dass diese im Messwertgeber gebildeten Frequenzen den Resonator anregen, woraufhin dieser auf seiner Messfrequenz, die unterschiedlich von den Speisefrequenzen ist, die Messwertinformation an einen Empfänger im Messsystem sendet, der seinerseits die Messwertinformation zur weiteren Auswertung zur Verfügung stellt.

Der Oberbegriff des Ansprüchs 1 stützt sich auf Merkmale aus WO 97/45277.

Der Erfindung liegt somit die Aufgabe zugrunde, ein Erzeugnis, ein Verfahren und eine Anordnung der jeweils eingangs genannten Art anzugeben, deren jedes die geschilderten Nachteile vermeidet und eine Messung einer einem reaktiven Widerstand entsprechenden Meßgröße erlaubt, welche nicht durch die Notwendigkeit eines Kompromisses zwischen der erzielbaren Auflösung und der erzielbaren Reichweite beschränkt ist.

Zur Lösung dieser Aufgabe angegeben wird ein Erzeugnis mit einem Sensor, durch welchen eine einem reaktiven Widerstand entsprechende Meßgröße innerhalb eines Meßbereichs lieferbar ist, einem Anpassnetzwerk und einem Oberflächenwellenelement, wobei der Sensor über das Anpassnetzwerk an einen ersten Reflektor des Oberflächenwellenelements geschaltet ist, wobei der erste Reflektor mit dem Anpassnetzwerk und dem Sensor einen Resonator bildet, welcher für einen Wert der Meßgröße innerhalb des Meßbereichs eine Resonanz hinsichtlich einer Reflexion einer auf dem Oberflächenwellenelement sich ausbreitenden akustischen Oberflächenwelle an dem ersten Reflektor aufweist.

Zur Lösung dieser Aufgabe angegeben wird ein Verfahren zum Bestimmen einer einem reaktiven Widerstand entsprechenden Meßgröße innerhalb eines Meßbereichs von einem Sensor, welcher über ein Anpassnetzwerk an einen ersten Reflektor eines Oberflächenwellenelements geschaltet ist und mit dem ersten Reflektor und dem Anpassnetzwerk einen Resonator bildet, welcher Resonator für einen Wert der Meßgröße innerhalb des Meßbereichs eine Resonanz hinsichtlich einer Reflexion einer auf dem Oberflächenwellenelement sich ausbreitenden akustischen Oberflächenwelle an dem ersten Reflektor aufweist, umfassend folgende Schritte:
a) Erzeugen einer sich auf dem Oberflächenwellenelement ausbreitenden akustischen Oberflächenwelle;
b) Erzeugen einer ersten reflektierten Oberflächenwelle durch Reflektieren der Oberflächenwelle an dem ersten Reflektor;
c) Empfangen der ersten reflektierten Oberflächenwelle; und
d) Bestimmen der Meßgröße aus einer Phase der ersten reflektierten Oberflächenwelle.

Zur Lösung dieser Aufgabe wird angegeben eine Anordnung zum Bestimmen einer einem reaktiven Widerstand entsprechenden Meßgröße von einem Sensor, welcher über ein Anpassnetzwerk an einen ersten Reflektor eines Oberflächenwellenelements geschaltet ist und mit dem ersten Reflektor und dem Anpassnetzwerk einen Resonator bildet, welcher Resonator für einen Wert der Meßgröße innerhalb des Meßbereichs eine Resonanz hinsichtlich einer Reflexion einer auf dem Oberflächenwellenelement sich ausbreitenden akustischen Oberflächenwelle an dem ersten Reflektor aufweist, umfassend Mittel zum:
a) Erzeugen einer sich auf dem Oberflächenwellenelement ausbreitenden akustischen Oberflächenwelle;
b) Empfangen einer durch Reflektieren der Oberflächenwelle an dem ersten Reflektor erzeugten ersten reflektierten Oberflächenwelle; und
c) Bestimmen der Meßgröße aus einer Phase der ersten reflektierten Oberflächenwelle.

Erfindungsgemäß wird demnach die Auswertung einer Amplitude einer reflektierten Oberflächenwelle ersetzt durch eine Auswertung einer Phase der reflektierten Oberflächenwelle. Dies erfordert eine spezifische Maßnahme an dem Sensormodul, denn die Variabilität der Phase in Abhängigkeit von einer reaktiven Meßgröße ist dann am größten, wenn die Abhängigkeit der Amplitude der reflektierten Oberflächenwelle von der Meßgröße am geringsten ist. Dies ergibt sich dann, wenn die zur Abfrage genutzte Frequenz eine Resonanzfrequenz des aus dem Sensor, dem Anpassnetzwerk und dem ersten Reflektor gebildeten Resonators ist. Dies schließt eine Auswertung der Amplitude der reflektierten Oberflächenwelle aus, weil die Amplitude zumindest in einem Teil des Meßbereichs keine eindeutige Abhängigkeit von der Meßgröße mehr aufweist. Damit einher geht, daß der Dynamikbereich der Amplitude der reflektierten Oberflächenwelle gegenüber den Möglichkeiten des Standes der Technik wesentlich reduziert wird, womit sich das Problem der Einhaltung eines notwendigen minimalen Rauschabstandes wesentlich reduziert. Auch ist die Abhängigkeit der Meßgröße selbst von der direkt zu messenden Amplitude reduziert, woraus sich eine wesentlich reduzierte Abhängigkeit der zu betrachtenden Meßfehler von der Meßgröße ergibt.

Es werden nun bevorzugte Weiterbildungen der Erfindung beschrieben; es versteht sich, daß diese gedacht sind für alle drei vorstehend beschriebenen Ausprägungen der Erfindung, nämlich Erzeugnis, Verfahren und Anordnung.

Eine bevorzugte Weiterbildung besteht darin, daß die Resonanz durch einem maximale Reflektivität des ersten Reflektors bestimmt ist. Derart wird die Amplitude der reflektierten Oberflächenwelle maximiert, was die erreichbare Auflösung der Messung wesentlich fördert.

Ebenfalls bevorzugt ist es, daß die Resonanz innerhalb des Meßbereiches einzig ist; auch dies kommt einer möglichst geringen Dynamik der Amplitude der reflektierten Oberflächenwelle zugute.

Die Meßgröße ist vorzugsweise eine Kapazität, entsprechend also der Wahl eines kapazitiven Sensors, insbesondere eines Drucksensors. Dabei ist weiterhin bevorzugt das Anpassnetzwerk eine mit dem Sensor in Serie geschaltete Induktivität.

Das Oberflächenwellenelement ist vorzugsweise mit einem zweiten Reflektor ausgestattet, welcher weiterhin vorzugsweise unbeschaltet ist. Der zweite Reflektor dient dazu, neben der erwähnten ersten reflektierten Oberflächenwelle eine zweite reflektierte Oberflächenwelle zu bilden. Diese zweite reflektierte Oberflächenwelle kann verwendet werden als Bezugssignal zur Ermittlung der Phase der ersten reflektierten Oberflächenwelle. Damit kann die Messung der Phase weitgehend unabhängig von Einflüssen der Umgebung vorgenommen werden.

Dies ist von besonderer Bedeutung dann, wenn der Sensor in einem rotierenden Kraftfahrzeugreifen eingesetzt ist. Damit ergibt sich nämlich eine Variabilität der Phase zwischen dem rotierenden Sensor und dem am Kraftfahrzeug fest installierten Auswertegerät, welche die Messung unter Umständen beeinträchtigen könnte, jedoch nicht die Messung unter Verwendung der zweiten reflektierten Oberflächenwelle. Auch ist in Betracht zu ziehen, daß die Messung beeinträchtigt werden könnte durch eine schwankende Temperatur des Oberflächenwellenelements. Ein solcher Einfluß kann unter Verwendung eines zweiten Reflektors oder mehrerer zweiten Reflektoren ermittelt und die Bestimmung der gewünschten Meßgröße gegebenenfalls korrigiert werden. Ein beschalteter zweiter Sensor kann vorgesehen sein für eine zusätzliche Messung zum Zwecke des Vergleichs, der Kalibrierung oder der Kompensation eines ansonsten störenden Einflusses.

Das Oberflächenwellenelement weist mit besonderem Vorzug einen elektroakustischen Wandler auf, an welchen eine Antenne geschaltet ist. Derart kann die Oberflächenwelle erzeugt werden, indem der Antenne ein pulsförmiges, eingehendes elektromagnetisches hochfrequentes Signal zugesandt wird; auch wird die erste reflektierte Oberflächenwelle bzw. jede reflektierte Oberflächenwelle übermittelt, indem sie durch den Wandler in ein entsprechendes ausgehendes elektromagnetisches Signal gewandelt und über die Antenne ausgesandt wird.

In diesem Zusammenhang ist vorzugsweise ein mechanisch von dem Sensor und dem Oberflächenwellenelement getrenntes Auswertegerät vorgesehen, welches einen Sendeempfänger zum Erzeugen des zu der Antenne zu sendenden und durch den Wandler zu wandelnden eingehenden elektromagnetischen Signals und zum Empfangen jedes durch den Wandler gewandelten ausgehenden elektromagnetischen Signals sowie einen Phasendiskriminator zur Bestimmung der Meßgröße aufweist. Wie dieser Phasendiskriminator ausgestaltet ist, bleibt dem Ermessen der einschlägig bewanderten und tätigen Person überlassen; im einfachsten Fall kann die Phase des empfangenen Signals relativ zur Phase eines Oszillators, welcher das zu dem Sensor gesandte elektromagnetische Signal erzeugt hat, bestimmt werden. Ein entsprechender Phasendiskriminator läßt sich in herkömmlicher analoger Hochfrequenztechnologie realisieren. Alternativ kann der Phasendiskriminator so funktionieren, daß er sowohl für die erste reflektierte Oberflächenwelle als auch für die zweite reflektierte Oberflächenwelle ein jeweiliges ausgehendes elektromagnetisches Signal zunächst speichert und dann die beiden gespeicherten Signale miteinander vergleicht; zu diesem Zweck kann ein in digitaler Technik realisierter, mit einem entsprechenden Programm versehener Signalprozessor zum Einsatz kommen.

Ausführungsbeispiele der Erfindung werden nunmehr anhand der Zeichnung erläutert. Die Figuren der Zeichnung sind teilweise schematisiert ausgeführt; in keinem Fall wird geltend gemacht, daß die Zeichnung eine maßstabsgerechte Wiedergabe enthalte. Zur Vervollständigung der nachfolgenden Ausführungen und der aus der Zeichnung direkt entnehmbaren Hinweise wird auf das parate Fachwissen der einschlägig bewanderten und tätigen Personen sowie auf die zitierten Dokumente des Standes der Technik verwiesen. Im einzelnen zeigen:
- Figur 1: eine Anordnung wie vorstehend beschrieben, umfassend ein Erzeugnis wie vorstehend beschrieben;
- Figur 2: eine spezielle Ausgestaltung des Erzeugnisses gemäß Figur 1;
- Figur 3: und Figur 4 Meßergebnisse, erhalten an einem Erzeugnis wie dargestellt in Figur 2.

Figur 1 zeigt ein Erzeugnis umfassend einen Sensor 1, welcher über ein Anpassnetzwerk 2 an ein Oberflächenwellenelement 3, und zwar an einen ersten Reflektor 4 dieses Oberflächenwellenelements 3, geschaltet ist. Der erste Reflektor 4 wechselwirkt mit einer sich auf dem Oberflächenwellenelement 3, welches aus einem piezoelektrischen Substrat besteht, insbesondere Lithiumniobat, sich ausbreitenden akustischen Oberflächenwelle. Dies geschieht derart, daß die Oberflächenwelle in dem ersten Reflektor 4 ein elektrisches Signal erzeugt, welches seinerseits zurückwirkt auf das piezoelektrische Substrat, wodurch eine erste reflektierte Oberflächenwelle gebildet wird. Auch diese breitet sich, ausgehend von dem ersten Reflektor 4, auf dem Oberflächenwellenelement 3 aus. Diese Reflexionseigenschaft des ersten Reflektors 4 ist abhängig von seiner äußeren Beschaltung, welche gegeben ist durch das Anpassnetzwerk 2 und den Sensor 1. Sowohl der Sensor 1 als auch das Anpassnetzwerk 2 stellen in erster Linie jeweils einen reaktiven Widerstand oder ein Netzwerk solcher reaktiver Widerstände dar. Der erste Reflektor 4 bildet mit dem Anpassnetzwerk 2 und dem Sensor 1 einen Resonator hinsichtlich einer Reflexion einer auf dem Oberflächenwellenelement 3 sich ausbreitenden akustischen Oberflächenwelle an dem ersten Reflektor 4, wie vorstehend angedeutet. Der Resonator hat Eigenschaften, welche sich verändern entsprechend einer Veränderung des reaktiven Widerstandes des Sensors 1, wobei diese Veränderung innerhalb eines durch den Aufbau des Sensors 1 vorbestimmten Meßbereichs erfolgt. Der reaktive Widerstand des Sensors 1 ist die gewünschte Meßgröße. Der Resonator ist durch geeignete Wahl des Anpassnetzwerks 2 in Abhängigkeit von den maßgeblichen Eigenschaften des Sensors 1 so gestaltet, daß er für einen Wert der Meßgröße innerhalb des Meßbereichs eine Resonanz hinsichtlich einer Reflexion einer auf dem Oberflächenwellenelement 3 sich ausbreitenden akustischen Oberflächenwelle an dem ersten Reflektor 4 aufweist. Dies hat den Vorzug, daß sich die Phase der durch die Reflexion erzeugten ersten reflektierten Oberflächenwelle mit der Meßgröße verändert, wobei allerdings eine Amplitude der ersten reflektierten Oberflächenwelle vergleichsweise konstant bleibt. Dadurch ist es möglich, durch Auswertung der Phase der ersten reflektierten Oberflächenwelle eine präzise und eine hohe Auflösung ermöglichende Messung der Meßgröße vorzunehmen. Zweckmäßig ist die Resonanz durch eine maximale Reflektivität des ersten Reflektors bestimmt, so daß bei Eintreten der Resonanz die Amplitude der ersten reflektierten Oberflächenwelle ein Maximum hat. Dies stellt sicher, daß über den gesamten Meßbereich die Amplitude der ersten reflektierten Oberflächenwelle größtmöglich ist. Dem gleichen Zweck dient es, daß die Resonanz innerhalb des Meßbereichs einzig ist, da zwei direkt aufeinanderfolgende Resonanzen eines elektromagnetischen Schaltkreises stets die Eigenschaft haben, daß eine Resonanz durch maximale und die andere Resonanz durch minimale Amplitude bestimmt ist. Eine einzige Resonanz mit maximaler Reflektivität wie beschrieben stellt sicher, daß über den gesamten Meßbereich eine möglichst hohe Amplitude der reflektierten Oberflächenwelle erreicht wird.

Das Oberflächenwellenelement 3 weist neben dem ersten Reflektor 4 auch einen zweiten Reflektor 5 auf, welcher unbeschaltet ist. Dieser zweite Reflektor 5 bildet eine zweite reflektierte Oberflächenwelle, und zweckmäßig wird die zur Ermittlung der Meßgröße gewünschte Phase der ersten reflektierten Oberflächenwelle bestimmt durch einen Vergleich mit der Phase der zweiten reflektierten Oberflächenwelle, welche aufgrund der mangelnden Beschaltung des zweiten Reflektors 5 stets konstant ist. Die zweite reflektierte Oberflächenwelle kann gegebenenfalls auch genutzt werden, um einen Störeinfluß, beispielsweise aus einer schwankenden Temperatur des Oberflächenwellenelements 3, auszuschließen.

Das Oberflächenwellenelement 3 weist auch einen elektroakustischen Wandler 6 auf. Dieser definiert eine eindeutige Beziehung zwischen einer auf dem Oberflächenwellenelement 3 sich ausbreitenden Oberflächenwelle und einem elektrischen Signal, welches an dem elektroakustischen Wandler 6 anliegt. Der Wandler 6 dient dazu, ein über die Antenne 7 eingehendes elektromagnetisches Signal in eine akustische Oberflächenwelle zu transformieren, welche dann zum ersten Reflektor 4 und zum zweiten Reflektor 5 läuft, und die von diesen Reflektoren 4 und 5 erzeugten reflektierten Oberflächenwellen wieder in entsprechende über die Antenne 7 ausgehende elektromagnetische Signale zu wandeln.

Das beschriebene Erzeugnis gehört zu einer Anordnung zum Bestimmen der einem reaktiven Widerstand entsprechenden Meßgröße von dem Sensor 1, welcher zusätzlich zu dem Erzeugnis ein Auswertegerät 8 aufweist. Der Wandler 6, die Antenne 7 und das Auswertegerät 8 bilden Mittel zum Erzeugen einer sich auf dem Oberflächenwellenelement ausbreitenden akustischen Oberflächenwelle, zum Empfangen einer durch Reflektieren der Oberflächenwelle an dem ersten Reflektor 4 erzeugten ersten reflektierten Oberflächenwelle und Bestimmen der Meßgröße aus einer Phase der ersten reflektierten Oberflächenwelle. Das Auswertegerät umfaßt zu diesem Zweck einen Sende-Empfänger 9 und einen Phasendiskriminator 10. Der Sendeempfänger 9 dient zum Erzeugen eines zu dem Erzeugnis zu sendenden eingehenden elektromagnetischen Signals und zum Empfangen eines durch Wandlung der ersten reflektierten Oberflächenwelle in dem Erzeugnis gebildeten ausgehenden elektrischen Signals. In dem Phasendiskriminator 10 wird die Phase des ausgehenden elektromagnetischen Signals und damit die Phase der ersten reflektierten Oberflächenwelle sowie daraus die Meßgröße bestimmt. Zur Wiedergabe der Meßgröße besitzt das Auswertegerät 8 im einfachsten Fall eine entsprechende Anzeigeeinrichtung, wie angedeutet. Von der Darstellung von Einzelheiten zur Ausgestaltung des Auswertegerätes 8 wird an dieser Stelle abgesehen, da diese Einzelheiten einer einschlägig bewanderten und tätigen Person in ausreichendem Umfang geläufig sind. Zusätzlich wird auf obige Ausführungen zu einer vorteilhaften Ausgestaltung der Erfindung verwiesen.

Figur 2 zeigt eine bevorzugte Ausgestaltung des Erzeugnisses. Der Sensor 1 ist dabei ein kapazitiver Sensor, beispielsweise ein Drucksensor, in einem Reifen eines Kraftfahrzeuges. Der Drucksensor entspricht elektrisch einem Kondensator mit innerhalb eines Meßbereichs variabler Kapazität, und die Kapazität ist auch die vorliegend maßgebliche Meßgröße. Das Anpassnetzwerk 2 ist vorliegend lediglich eine mit dem Sensor 1 in Serie geschaltete Induktivität 2, und der aus dem Sensor 1 und der Induktivität 2 somit gebildete Serienresonanzkreis ist an den ersten Reflektor 4 des Oberflächenwellenelements 3 geschaltet. Der somit aus dem ersten Reflektor 4 und dem Serienresonanzkreis gebildete Resonator weist überhaupt nur eine einzige Resonanz auf, mithin insbesondere eine einzige Resonanz innerhalb des Meßbereiches. Auch ist dieser Reflektor so eingerichtet, daß die Reflektivität des ersten Resonators 4 im Punkt der Resonanz maximal ist - es wird also im Punkt der Resonanz eine erste reflektierte Oberflächenwelle mit maximaler Amplitude erzeugt, und dies beinhaltet, daß die Amplitude innerhalb des Meßbereiches jedenfalls immer relativ hoch ist. Dies kommt der Erzielung eines geringen Meßfehlers und damit einer hohen Auflösung entgegen.

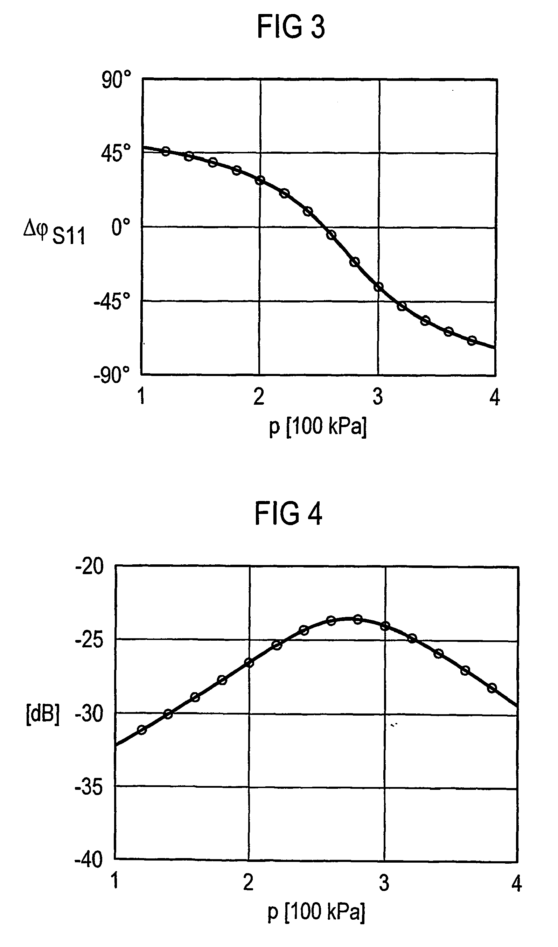

Die Figuren 3 und 4 zeigen Meßwerte, erhalten an einem Erzeugnis gemäß Figur 2. Dieses Erzeugnis ist ausgelegt für eine Frequenz der akustischen Oberflächenwelle von 433,92 MHz entsprechend einer Frequenz aus einem genormten ISM-Frequenzband. Das Oberflächenwellenelement 3 besteht aus Lithiumniobat mit einer Länge von 13 mm und einer Breite von 2 mm, mit einer Laufzeit der akustischen Oberflächenwelle vom Wandler 6 zum ersten Reflektor 4 und zurück von 7 µs und einem ersten Reflektor 4 sowie einem Wandler 6 bestehend aus Aluminium. Als Sensor 1 kommt zum Einsatz ein Differenzdrucksensor aus Quarz mit einem Meßbereich zwischen 1,5 pF entsprechend 100 kPa Differenzdruck bis 5 pF entsprechend 400 kPa Differenzdruck und einem ohmschen Verlustwiderstand von 3 Ohm. Der Sensor 1 besteht aus einer quadratischen Membran mit einer Seitenlänge von 20 mm; zur praktischen Anwendung wird ein Sensor mit bedeutend verringerten Abmessungen in Betracht gezogen. Als Anpassnetzwerk 2 dient eine mit dem Sensor 1 in Serie geschaltete Spule 2 mit einer Induktivität von 100 nH. Für dieses Erzeugnis wird eine Variabilität der zur Bestimmung der Meßgröße auszuwertenden Phase von mehr als 90° festgestellt, wie erkennbar aus Figur 3. Die Variabilität der Amplitude der reflektierten Oberflächenwelle ergibt sich aus Figur 4; sie beträgt etwa 10 dB ist damit recht klein; auch erkennt man, daß die Beziehung zwischen der Amplitude und dem gemessenen Druck nicht eindeutig ist. Figur 4 zeigt die Amplitude der ersten reflektierten Oberflächenwelle relativ zur Amplitude der von dem Wandler 6 zum ersten Reflektor 4 laufenden Oberflächenwelle in logarithmischer Darstellung; der aus Figur 4 erkennbare Faktor wird geläufig als "Rückflussdämpfung" bezeichnet. Die Variabilität der Amplitude gemäß Figur 4 ist jedenfalls ausreichend, um unter geeigneten Randbedingungen im Rahmen einer Anordnung gemäß Figur 1 in jedem Fall einen ausreichenden Rauschabstand zu gewährleisten, bei gleichzeitig hoher Empfindlichkeit für die Meßgröße wie erkennbar aus Figur 3. Das beschriebene Erzeugnis ist somit hervorragend verwendbar zur Bestimmung eines Betriebsparameters eines Reifens in einem Kraftfahrzeug, wobei das Oberflächenwellenelement 3 nebst Antenne 7, Anpassnetzwerk 2 und Sensor 1 in dem Reifen angebracht ist und das Auswertegerät 8 von dem Reifen getrennt postiert ist.

## Patentansprüche

1. Erzeugnis mit einem Sensor (1), durch welchen eine einem reaktiven Widerstand entsprechende Meßgröße innerhalb eines Meßbereichs lieferbar ist, einem Anpassnetzwerk (2) und einem Oberflächenwellenelement (3), wobei der Sensor (1) über das Anpassnetzwerk (2) an einen ersten Reflektor (4) des Oberflächenwellenelements (3) geschaltet ist und der erste Reflektor (4) mit dem Anpassnetzwerk (2) und dem Sensor (1) einen Resonator bildet,
**dadurch gekennzeichnet, dass** das Anpassnetzwerk (2) derart ausgebildet ist, dass der Resonator für einen Wert der Meßgröße innerhalb des Meßbereichs eine Resonanz hinsichtlich einer Reflexion einer auf dem Oberflächenwellenelement (3) sich ausbreitenden akustischen Oberflächenwelle an dem ersten Reflektor (4) aufweist.

2. Erzeugnis nach Anspruch 1, bei dem die Resonanz durch eine maximale Reflektivität des ersten Reflektors (4) bestimmt ist.

3. Erzeugnis nach einem der vorigen Ansprüche, bei dem die Resonanz innerhalb des Meßbereichs einzig ist.

4. Erzeugnis nach einem der vorigen Ansprüche, bei dem die Meßgröße eine Kapazität ist.

5. Erzeugnis nach Anspruch 4, bei dem das Anpassnetzwerk (2) eine mit dem Sensor (1) in Serie geschaltete Induktivität (2) ist.

6. Erzeugnis nach einem der vorigen Ansprüche, bei dem das Oberflächenwellenelement (3) einen zweiten Reflektor (5) aufweist.

7. Erzeugnis nach Anspruch 6, bei dem der zweite Reflektor (5) unbeschaltet ist.

8. Erzeugnis nach einem der vorigen Ansprüche, bei dem das Oberflächenwellenelement (3) einen elektroakustischen Wandler (6) aufweist, an welchen eine Antenne (7) geschaltet ist.

9. Verfahren zum Bestimmen einer einem reaktiven Widerstand entsprechenden Meßgröße innerhalb eines Meßbereichs von einem Sensor (1), welcher über ein Anpassnetzwerk (2) an einen ersten Reflektor (4) eines Oberflächenwellenelements (3) geschaltet ist und mit dem ersten Reflektor (4) und dem Anpassnetzwerk (2) einen Resonator bildet, umfassend folgende Schritte:
a) Bereitstellen des Anpassnetzwerks (2) derart, dass der Resonator für einen Wert der Meßgröße innerhalb des Meßbereichs eine Resonanz hinsichtlich einer Reflexion einer auf dem Oberflächenwellenelement (3) sich ausbreitenden akustischen Oberflächenwelle an dem ersten Reflektor (4) aufweist,
b) Erzeugen einer sich auf dem Oberflächenwellenelement (3) ausbreitenden akustischen Oberflächenwelle;
c) Erzeugen einer ersten reflektierten Oberflächenwelle durch Reflektieren der Oberflächenwelle an dem ersten Reflektor (4) ;
d) Empfangen der ersten reflektierten Oberflächenwelle; und
e) Bestimmen der Meßgröße aus einer Phase der ersten reflektierten Oberflächenwelle.

10. Verfahren nach Anspruch 9, bei dem die Oberflächenwelle aus einem eingehenden elektromagnetischen Signal und die reflektierte Oberflächenwelle in ein ausgehendes elektromagnetisches Signal gewandelt, und die Meßgröße aus dem ausgehenden elektromagnetischen Signal bestimmt wird.

11. Verfahren nach Anspruch 10, bei dem das eingehende Signal über eine Antenne (7) empfangen und das ausgehende Signal über die Antenne (7) ausgesendet wird.

12. Verfahren nach einem der Ansprüche 9 bis 11, bei dem durch Reflektieren der Oberflächenwelle an einem zweiten Reflektor (5) des Oberflächenwellenelements (3) eine zweite reflektierte Oberflächenwelle erzeugt, die zweite reflektierte Oberflächenwelle ebenfalls empfangen und die Meßgröße aus einer Phasendifferenz zwischen der ersten und der zweiten reflektierten Oberflächenwelle bestimmt wird.

13. Anordnung zum Bestimmen einer einem reaktiven Widerstand entsprechenden Meßgröße innerhalb eines Meßbereichs von einem Sensor (1), welcher über ein Anpassnetzwerk (2) an einen ersten Reflektor (4) eines Oberflächenwellenelements (3) geschaltet ist und mit dem ersten Reflektor (4) und dem Anpassnetzwerk (2) einen Resonator bildet, wobei das Anpassnetzwerk (2) derart ausgebildet ist, dass der Resonator für einen Wert der Meßgröße innerhalb des Meßbereichs eine Resonanz hinsichtlich einer Reflexion einer auf dem Oberflächenwellenelement (3) sich ausbreitenden akustischen Oberflächenwelle an dem ersten Reflektor (4) aufweist, umfassend Mittel (6, 7, 8) zum:
a) Erzeugen einer sich auf dem Oberflächenwellenelement (3) ausbreitenden akustischen Oberflächenwelle;
b) Erzeugen einer durch Reflektieren der Oberflächenwelle an dem ersten Reflektor (4) erzeugten ersten reflektierten Oberflächenwelle; und
c) Bestimmen der Meßgröße aus einer Phase der ersten reflektieren Oberflächenwelle.

14. Anordnung nach Anspruch 13, bei der die Mittel (6, 7, 8) einen elektroakustischen Wandler (6) auf dem Oberflächenwellenelement (3), eine an diesen geschaltete Antenne (7) sowie ein mechanisch von dem Sensor (1) und dem Oberflächenwellenelement (3) getrenntes Auswertegerät (8) umfassen.

15. Anordnung nach Anspruch 14, bei der das Auswertegerät (8) einen Sendeempfänger (9) zum Erzeugen eines zu der Antenne (7) zu sendenden und durch den Wandler (6) zu wandelnden eingehenden elektromagnetischen Signals und zum Empfangen eines durch den Wandler (6) gewandelten ausgehenden elektromagnetischen Signals sowie einen Phasendiskriminator (10) zur Bestimmung der Meßgröße aufweist.

## Claims

1. Product with a sensor (1), by which a measurement value within a measurement range corresponding to a reactive resistance is able to be delivered, an adaptation network (2) and a surface wave element (3), with the sensor (1) being connected via the adaptation network (2) to a first reflector (4) of the surface wave element (3) and the first reflector (4) with the adaptation network (2) and the sensor (1) forming a resonator,
**characterised in that** the adaptation network (2) is embodied such that the resonator, for a value of the measurement value within the measurement range, has a resonance in respect of a reflection of an acoustic surface wave propagating on the surface wave element (3) at the first reflector (4).

2. Product according to claim 1, in which the resonance is determined by a maximum reflectivity of the first reflector (4).

3. Product according to one of the previous claims, in which the resonance is unique within the measurement range.

4. Product according to one of the previous claims, in which the measurement value is a capacitance.

5. Product according to claim 4, in which the adaptation network (2) is an inductance connected in series with the sensor (1).

6. Product according to one of the previous claims, in which the surface wave element (3) features a second reflector (5).

7. Product according to claim 6, in which the second reflector (5) is not connected.

8. Product according to one of the previous claims, in which the surface wave element (3) features an electroacoustic converter (6) to which an antenna (7) is connected.

9. Method for determining a measurement value within a measurement range of a sensor (1) corresponding to a reactive resistance which is connected via an adaptation network (2) to a first reflector (4) of a surface wave element (3) and which, with first reflector (4) and the adaptation network, (2) forms a resonator, comprising the following steps:
a) Provision of the adaptation network (2) such that the resonator, for a value of the measurement value within the measurement range, has a resonance in respect of a reflection of an acoustic surface wave propagating on the surface wave element (3) at the first reflector (4),
b) Creation of an acoustic surface wave propagating on the surface wave element (3);
c) Creation of a first reflected surface wave by reflectors of the surface wave at the first reflector (4);
d) Receipt of the first reflected surface wave; and
e) Determination of the measurement value from a phase of the reflected surface wave.

10. Method according to claim 9, in which the surface wave from an incoming electromagnetic signal is converted into an outgoing electromagnetic signal, and the measurement value is determined from the outgoing electromagnetic signal.

11. Method according to claim 10, in which the incoming signal is received via an antenna (7) and the outgoing signal is sent out via the antenna (7).

12. Method according to one of claims 9 to 11, in which, by reflecting the surface wave at a second reflector (5) of the surface wave element (3), a second reflected surface wave is generated, which is likewise received and the measurement value is determined from a phase difference between the first and the second reflected surface wave.

13. Arrangement for determining a measurement value within a measurement range of a sensor (1) corresponding to a reactive resistance which is connected via an adaptation network (2) to a first reflector (4) of a surface wave element (3) and which, with the first reflector (4) and the adaptation network (2), forms a resonator, with the adaptation network (2) being embodied such that the resonator, for a value of the measurement value within the measurement range, has a resonance in respect of a reflection of an acoustic surface wave propagating on the surface wave element (3) at the first reflector (4), comprising means (6, 7, 8) for:
a) Creation of an acoustic surface wave propagating on the surface wave element (3);
b) Creation of a first reflected surface wave created by reflection of the surface wave at the first reflector (4); and
c) Determination of the measurement value from a phase of the reflected surface wave.

14. Arrangement according to claim 13, in which the means (6, 7, 8) comprise an electroacoustic converter (6) on the surface wave element (3), an antenna (7) connected to this, as well as an evaluation device (8) separated mechanically from the surface wave element (3).

15. Arrangement according to claim 14, in which the evaluation device (8) features a transceiver (9) for creating an electromagnetic signal to be sent to the antenna (7) and to be converted by the converter (6) and for receiving an outgoing electromagnetic signal converted by the converter (6) as well as a phase discriminator (10) for determining the measurement value.

## Revendications

1. Produit avec un capteur (1), par l'intermédiaire duquel une grandeur de mesure dans les limites d'une étendue de mesure correspondant à une résistance réactive peut être délivrée, un réseau d'adaptation (2) et un élément d'onde de surface (3), le capteur (1) étant connecté via le réseau d'adaptation (2) à un premier réflecteur (4) de l'élément d'onde de surface (3) et le premier réflecteur (4) formant un résonateur avec le réseau d'adaptation (2) et le capteur (1),
**caractérisé en ce que** le réseau d'adaptation (2) est réalisé de manière à ce que le résonateur présente, pour une valeur de la grandeur de mesure dans les limites de l'étendue de mesure, une résonance relative à une réflexion d'une onde de surface acoustique se propageant sur l'élément d'onde de surface (3) au niveau du premier réflecteur (4).

2. Produit selon la revendication 1, la résonance étant déterminée par une réflectivité maximale du premier réflecteur (4).

3. Produit selon l'une quelconque des revendications précédentes, la résonance dans les limites de l'étendue de mesure étant unique.

4. Produit selon l'une quelconque des revendications précédentes, la grandeur de mesure étant une capacité.

5. Produit selon la revendication 4, le réseau d'adaptation (2) étant une inductance (2) connectée en série avec le capteur (1).

6. Produit selon l'une quelconque des revendications précédentes, l'élément d'onde de surface (3) présentant un deuxième réflecteur (5).

7. Produit selon la revendication 6, le deuxième réflecteur (5) étant non connecté.

8. Produit selon l'une quelconque des revendications précédentes, l'élément d'onde de surface (3) présentant un convertisseur électroacoustique (6), auquel une antenne (7) est connectée.

9. Procédé pour déterminer une grandeur de mesure dans les limites d'une étendue de mesure correspondant à une résistance réactive d'un capteur (1), lequel est connecté via un réseau d'adaptation (2) à un premier réflecteur (4) d'un élément d'onde de surface (3) et forme un résonateur avec le premier réflecteur (4) et le réseau d'adaptation (2), comprenant les étapes suivantes :
a) mise à disposition du réseau d'adaptation (2) de manière à ce que le résonateur présente, pour une valeur de la grandeur de mesure dans les limites de l'étendue de mesure, une résonance relative à une réflexion d'une onde de surface acoustique se propageant sur l'élément d'onde de surface (3) au niveau du premier réflecteur (4),
b) génération d'une onde de surface acoustique se propageant sur l'élément d'onde de surface (3) ;
c) génération d'une première onde de surface réfléchie grâce à la réflexion de l'onde de surface au niveau du premier réflecteur (4) ;
d) réception de la première onde de surface réfléchie; et
e) détermination de la grandeur de mesure à partir d'une phase de la première onde de surface réfléchie.

10. Procédé selon la revendication 9, l'onde de surface étant déterminée à partir d'un signal électromagnétique entrant et l'onde de surface réfléchie étant convertie en un signal électromagnétique sortant, et la grandeur de mesure étant déterminée à partir du signal électromagnétique sortant.

11. Procédé selon la revendication 10, le signal entrant étant réceptionné par une antenne (7) et le signal sortant étant émis par l'intermédiaire de l'antenne (7).

12. Procédé selon l'une quelconque des revendications 9 à 11, une deuxième onde de surface réfléchie étant générée grâce à la réflexion de l'onde de surface au niveau d'un deuxième réflecteur (5) de l'élément d'onde de surface (3), la deuxième onde de surface réfléchie étant également réceptionnée et la grandeur de mesure étant déterminée à partir d'une différence de phase entre la première et la deuxième ondes de surface réfléchies.

13. Agencement pour déterminer une grandeur de mesure dans les limites d'une étendue de mesure correspondant à une résistance réactive d'un capteur (1), lequel est connecté par l'intermédiaire d'un réseau d'adaptation (2) à un premier réflecteur (4) d'un élément d'onde de surface (3) et forme un résonateur avec le premier réflecteur (4) et le réseau d'adaptation (2), le réseau d'adaptation (2) étant réalisé de manière à ce que le résonateur présente, pour une valeur de la grandeur de mesure dans les limites de l'étendue de mesure, une résonance relative à une réflexion d'une onde de surface acoustique se propageant sur l'élément d'onde de surface (3) au niveau du premier réflecteur (4), comprenant des moyens (6, 7, 8) afin de :
a) générer une onde de surface acoustique se propageant sur l'élément d'onde de surface (3) ;
b) générer une première onde de surface réfléchie obtenue par réflexion de l'onde de surface au niveau du premier réflecteur (4) ; et
c) déterminer la grandeur de mesure à partir d'une phase de la première onde de surface réfléchie.

14. Agencement selon la revendication 13, les moyens (6, 7, 8) comprenant un convertisseur électroacoustique (6) sur l'élément d'onde de surface (3), une antenne (7) connectée avec celui-ci ainsi qu'un appareil d'analyse (8) mécaniquement séparé du capteur (1) et de l'élément d'onde de surface (3).

15. Agencement selon la revendication 14, l'appareil d'analyse (8) présentant un émetteur-récepteur (9) pour générer un signal électromagnétique entrant à envoyer à l'antenne (7) et à convertir grâce au convertisseur (6) et pour réceptionner un signal électromagnétique sortant converti grâce au convertisseur (6) ainsi qu'un discriminateur de phase (10) pour déterminer la grandeur de mesure.
